# EUROPEAN PATENT APPLICATION

(11) **EP 2 116 637 A2**
(43) Date of publication of application: **11.11.2009**
(21) Application number: 09005113.7
(22) Date of filing: 07.04.2009
(51) Int. Cl.: C30B 11/00, C30B 15/10, C30B 29/06

(54) **Crucible for melting silicon and release agent used to the same**

(30) Priority: 07.05.2008 JP 2008121545; 29.09.2008 JP 2008250628; 29.09.2008 JP 2008250814
(71) Applicant: Covalent Materials Corporation, Shinagawa-ku, Tokyo 141-0032 (JP)
(72) Inventor: Ohashi, Tadashi, Hedano-shi Kanagawa (JP); Umemoto, Seijiro, Hedano-shi Kanagawa (JP); Hitoki, Go, Hedano-shi Kanagawa (JP)
(74) Representative: Grünecker, Kinkeldey, Stockmair & Schwanhäusser Anwaltssozietät

(57) **Abstract**

The crucible for melting silicon according to the present invention is a crucible for melting silicon including a crucible main body including a heat-resistant member, and a protective film formed at least on an inner surface of the crucible main body, in which the protective film has a composition of SiO_{X}N_{Y} in which X > 0 and Y > 0. The crucible for melting silicon according to the present invention has excellent releasability to a silicon block, reduces the amount of impurities dissolved in a silicon melt, and can be produced at low cost. Furthermore, the present invention provides a release agent for use in the production of the crucible for melting silicon.

## Description

### FIELD OF THE INVENTION

The present invention relates to a crucible for melting silicon, particularly, a crucible for melting silicon for use in the production of a polycrystal silicon substrate used for the formation of a solar cell, and a release agent used to the same.

### BACKGROUND OF THE INVENTION

In addition to a monocrystal silicon substrate produced by a Czochraski method, a polycrystal silicon substrate which may be easily increased in size is used as a substrate for forming a solar cell. Such polycrystal silicon substrate is produced by melting high purity silicon in a crucible for melting silicon (hereinafter simply referred to as a "crucible") or pouring a silicon melt melted at high temperature into the crucible, coagulating the melt to form a silicon crystal (hereinafter referred to as a "silicon block"), demolding the silicon block, and then slicing the silicon block thus demolded into a constant thickness.

As a crucible used for obtaining various silicon substrates, there has been required a crucible that does not react with a silicon melt and has excellent releasability to a coagulated silicon block. Quartz, graphite, platinum and the like have conventionally been used as a material for a crucible. However, those materials have had a problem that materials themselves constituting a crucible or impurities contained in the materials react with a silicon melt, resulting in contamination of the silicon melt.

To solve this problem, a crucible in which the surface of quartz is coated with a silicon nitride powder, a crucible in which the surface of graphite is coated with a molten film of alkali earth metal halide, a crucible in which the surface of graphite is coated with a silicon nitride film by a CVD method, a crucible in which a cermet sprayed film containing metal silicon, silicon oxide and silicon nitride is formed on the surface of fused quartz, and the like has been proposed (for example, see Patent Documents 1 and 2, and Non-Patent Documents 1 and 2).

Furthermore, a crucible provided with a release agent layer obtained by applying two layers having different weight ratio of silicon nitride and silicon dioxide, and a crucible provided with a release agent layer obtained by applying a silicon dioxide powder to the inner surface of a casting mold, applying thereon a mixed powder of a silicon dioxide powder and a silicon nitride powder, and further applying thereon a silicon nitride powder has been proposed (for example, see Patent Documents 3 and 4).

However, the crucible coated with a silicon nitride powder has a problem that because silicon nitride is brittle, the film of silicon nitride breaks, a silicon melt contacts with the crucible, a coagulated silicon block is adhered to the crucible, and cracks are generated in the silicon block at the time of demolding.

Furthermore, because nitrogen dissolves in a silicon melt, problems arise that when the silicon melt is solidified and crystallized in a crucible, crystal grains become fine, and when the amount of nitrogen dissolved is further increased, needle crystals of silicon nitride are precipitated in the crystal, resulting in deterioration of quality of silicon crystal obtained. Even in the case of forming a silicon nitride by a CVD method, the same problems as above are generated. Furthermore, the CVD method has an disadvantage that film formation is expensive.

Accordingly, a technology of increasing strength as a protective film by mixing silica with silicon nitride in a specific weight ratio has been generally known (for example, Patent Document 5).

However, silica has high adhesion to a silicon block. Therefore, in the case that a large amount of a silica component is present on the outermost surface of a protective film contacting with the silica block, adhesion between the silica block and the protective film is increased, and when the silicon block is demolded from the crucible, there is high risk that crack or breakage is generated in the silicon block.

Furthermore, the crucible coated with a melt film of alkali earth metal halide involves a problem that impurities and the alkali earth metal contained in the film dissolve in a silicon melt, resulting in decrease in purity of silicon crystal obtained.

Furthermore, the crucible having a cermet sprayed film formed thereon involves a problems that because smoothness of the surface of the sprayed film is poor, polishing for enhancing releasability to the silicon block is required, whereby the production cost as a crucible becomes increased. Furthermore, it is difficult to form a sprayed film having a uniform thickness, and there is a possibility that the film thickness becomes nonuniform or the ground (crucible) is exposed.

Therefore, when the silicon melt is solidified and crystallized in a crucible, the silicon block and the crucible are adhered on the portion at which the ground is exposed, or baking is generated. As a result, when the silicon block is taken out of the crucible, there is a possibility that cracks, scratches and flaking are generated in the silicon block. If such damages are generated in the silicon block, there arise such problems that a substrate having a given size is not obtained, and the amount of substrates obtained is decreased. In the case that the protective film is constituted of a multilayer structure, when rapid temperature gradient is generated in the laminating direction, there is a problem that the protective film is peeled between the layers laminated.

Furthermore, a crucible provided with a protective film of a multilayer structure using a mixed powder of silicon nitride and silicon dioxide similarly has the problem that when rapid temperature gradient is generated in the laminating direction, the protective film is peeled between the layers laminated.

To solve those problems, a crucible having formed thereon a two-layered release agent layer (hereinafter referred to as a "protective film") in which the ratio of the silicon nitride contained is changed, using a silicon nitride powder having a silica layer form on the surface thereof has been proposed (for example, Patent Document 6).

However, in the technology described in Patent Document 6, since a silica layer is present also between the outermost surface of the protective film contacting with a silicon melt and the silicon nitride powder, the silica layer is substantially formed continuously in a matrix shape in a thickness direction of the protective layer over from the outermost layer of the protective film to the portion contacting with the crucible. Accordingly, since the strength is high as a protective film, there is a possibility that the silica layer present on the outermost surface of the protective film is adhered to the silicon block, the protective film itself is not broken, and adhesion between the silica layer and the silicon block is maintained. As a result, in demolding the silicon block from the crucible, there is a risk that crack and breakage are generated in the silicon block.

Further, in the case that a silicon nitride powder having a silica layer formed on the surface thereof is used as a release agent as described in Patent Document 6, when thermal shock (for example, pouring a silicon melt melted at high temperature into a crucible) or physical shock (for example, the case that a polycrystal silicon and a protective layer are contacted when placing the bulk in a crucible) is generated due to difference in thermal expansion coefficient between the silica layer and silicon nitride, brittleness of silicon nitride, and the like, since the strength is slightly poor, there is a possibility that the protective film peels from the crucible main body, and the inner surface of the crucible main body is exposed. Furthermore, when the protective film is constituted of a multilayer, release agents used in the respective layers must be prepared and formed respectively, resulting in deterioration of productivity and complicated procedures. Moreover, in the case that thermal shock or physical shock is generated in the protective film, the protective film involves a risk of peeling between the layers laminated.
Patent Document 1 : JP-T-2001-510434 (the section of "Detailed Description of the Invention", and the like) (the term "JP-T" as used herein means a published Japanese translation of a PCT patent application)
Patent Document 2 : JP-A-2003-41357 (paragraph [0017] and the like)
Patent Document 3 : JP-A-2003-313023 (Claim 1 and the like)
Patent Document 4 : JP-A-7-206419 (Claim 3 and the like)
Patent Document 5 : JP-A-9-175809 (Claim 1 and the like)
Patent Document 6 : JP-A-2005-95924 (Claim 1 and the like)
Non-Patent Document 1 : Shinichi Shirosaki, "SiO2N2 Tainetsu Zairyou (SiO2N2 heat-resistant materials)", Ouyou Butsuri (Applied Physics), Vol. 39, No. 11, (1970), p.1036
Non-Patent Document 2 : Malcolm E. Washburn, "Silicon Oxynitride Refractories", Am. Ceram. Soc. Bull. 46, (1967) p.667

### SUMMARY OF THE INVENTION

In view of the above circumstances, the present inventors previously found that SiO_{X}N_{Y} (X ≠ 0 and Y ≠ 0) is effective as a material difficult to get wet with silicon melt, and proposed a crucible for melting silicon provided with a protective film having a composition of SiO_{X}N_{Y} (X ≠ 0 and Y ≠ 0) (for example, JP-A-2008-115056 (Claim 1 and the like)). The present inventors have further made intensive studies for the purpose of providing a crucible for melting silicon, which has excellent releasability to a silicon block, reduces the amount of impurities dissolved in a silicon melt, and can be produced at low cost; a crucible for melting silicon provided with a protective film having excellent releasability, that can suppress generation of crack and breakage of a silicon block due to adhesion between the protective film and the silicon block by the collapse of the protective film itself; and a crucible for melting silicon, from which the protective film does not peel even in the case that thermal shock or physical shock is generated, and which is provided with a protective film having excellent releasability; and further providing release agents for use in the production of these crucibles for melting silicon. As a result, the present inventors have achieved the present invention.

A crucible for melting silicon according to the invention is a crucible for melting silicon comprising a crucible main body comprising a heat resistant member, and a protective film formed at least on an inner surface of the crucible main body, wherein the protective film has a composition of SiO_{X}N_{Y} in which X > 0 and Y > 0.

It is preferred that the protective film is constituted of a sintered body of a powder having a single composition of SiO_{X}N_{Y} in which X > 0 and Y > 0.

It is preferred that the SiO_{X}N_{Y} composition of the sintered body of the powder having a single composition satisfies 0.2 ≤ X ≤ 0.8 and 0.8 ≤ Y ≤ 1.2.

It is preferred that the protective film constituted of the sintered body of the powder having a single composition has such a composition gradient that Y is decreased and X is increased toward the depth direction thereof from the surface thereof.

It is preferred that the protective layer is constituted of a sintered body of a powder having a composition of SiO_{X}N_{Y} in which X > 0 and Y > 0, and the powder is an aggregate of fine particles having such a composition gradient that Y is decreased and X is increased toward the depth direction thereof from the surface thereof.

It is preferred that the protective film is a dense body.

It is preferred that the protective film is constituted of a dense body, and has such a composition gradient that Y is decreased and X is increased toward the depth direction thereof from the surface thereof.

It is preferred that the protective film contains alkali metal, alkali earth metal, fluoride, chloride, carbon, iron, chromium, cobalt, nickel, tungsten, molybdenum and titanium at a total concentration of 100 ppm or less.

It is preferred that the crucible for melting silicon is formed by combining a plurality of plate-like materials comprising a heat-resistant member having the protective film formed on a surface thereof.

In the crucible for melting silicon according to the invention, since the protective film formed at least on the inner surface of the crucible is difficult to get wet with silicon crystal, even in the case that a silicon melt is crystallized in the crucible, a silicon block thus crystallized can easily be taken out of the crucible. Furthermore, since the amount of impurities dissolved in the silicon melt from the protective film is small, silicon crystal having high quality can be obtained. Furthermore, since the protective film is easily formed on a crucible main body without using a post-treatment such as polishing and a CVD method, production economy is good, and a crucible for melting silicon having high quality and excellent releasability as described above can be produced at low cost.

A release agent according to the invention is a release agent for use in forming a protective film formed at least on an inner surface of a crucible for melting silicon, wherein the release agent comprises a powder of fine particles having, at least on the surface thereof, a single composition of SiO_{X}N_{Y} in which X > 0 and Y > 0.

It is preferred the composition of SiO_{X}N_{Y} satisfies 0.2 ≤ X ≤ 0.8 and 0.8 ≤ Y ≤ 1.2.

Another release agent according to the invention is a release agent for use in forming a protective film formed at least on an inner surface of a crucible for melting silicon, wherein the release agent comprises a powder having, at least on the surface thereof, a composition of SiO_{X}N_{Y} in which X > 0 and Y > 0, and the powder is an aggregate of fine particles having such a composition gradient that Y is decreased and X is increased toward the depth direction thereof from the surface thereof.

Another crucible for melting silicon according to the invention is a crucible for melting silicon comprising a crucible main body comprising a heat-resistant material, and a protective film formed at least on an inner surface of the crucible main body, wherein the protective film comprises first solid particles having, at least on the surface thereof, a composition of SiO_{X}N_{Y} in which X > 0 and Y > 0; and second solid particles having a composition of SiO₂ and having a particle diameter smaller than a particle diameter of the first solid particles, and the second particles connect the first solid particles with each other at a part of an interface between the first solid particles.

Owing to such a constitution, a crucible for melting silicon provided with a protective film having excellent releasability, that can suppress generation of crack and breakage of a silicon block due to adhesion between the protective film and the silicon block by the collapse of the protective film itself when demolding the silicon block from the crucible can be obtained.

It is preferred that the heat-resistant member is constituted of quartz.

Owing to such a constitution, the thermal expansion coefficients of the first solid particle, the second solid particles and the crucible main body become near or equal as compared with other materials, and generation of thermal stress due to difference in composition is suppressed. As a result, even in the case that thermal shock or physical shock is generated in the crucible for melting silicon, breakage and peeling of the entire protective film can be prevented.

Still anther release agent according to the invention is a release agent for use in forming a protective film formed at least on an inner surface of a crucible for melting silicon, wherein the release agent comprises a powder comprising first solid particles having, at least on the surface thereof, a composition of SiO_{X}N_{Y} in which X > 0 and Y > 0; and second solid particles having a composition of SiO₂ and having a particle diameter smaller than a particle diameter of the first solid particles.

By using the release agent having such a constitution, a crucible for melting silicon provided with the protective film having the above-described effects can be obtained.

Still another crucible for melting silicon according to the invention is a crucible for melting silicon comprising a crucible main body comprising a heat-resistant material, and a protective film formed at least on an inner surface of the crucible main body, wherein, in the protective film, a plurality of solid particles in which an oxide film is formed on the surface thereof and a direct inner layer of the oxide film has a composition of SiO_{X}N_{Y} in which X > 0 and Y > 0 are connected with each other through the oxide film.

Owing to such a constitution, a crucible for melting silicon from which the protective film does not peel even in the case that thermal shock or physical shock is generated, and which is provided with the protective film having excellent releasability can be obtained.

Still further another release agent according to the invention is a release agent for use in forming a protective film formed at least on an inner surface of a crucible for melting silicon, wherein the release agent comprises a powder comprising a plurality of solid particles in which an oxide film is formed on the surface thereof and a direct inner layer of the oxide film has a composition of SiO_{X}N_{Y} in which X > 0 and Y > 0.

By using the release agent having such a constitution, a crucible for melting silicon provided with the protective film having the above-described effects can be obtained.

The invention is particularly preferred to a crucible for melting silicon used in the production of monocrystal silicon which is a substrate of a silicon wafer to be used as a substrate of a semiconductor device, and a crucible for melting silicon used in the production of a polycrystal silicon block which is a substrate of a polycrystal silicon substrate used in a solar cell.

### BRIEF DESCRIPTION OF THE DRAWINGS

Fig. 1 is a sectional view showing a schematic structure of a crucible for melting silicon according to first to third embodiments of the present invention.
Fig. 2 is a view showing concentration distribution in depth direction of oxygen and nitrogen in SiO_{X}N_{Y} particle having a composition gradient.
Fig. 3 is a perspective view showing one example of a crucible for melting silicon according to a fourth embodiment of the invention.
Fig. 4 is a sectional view of A-A direction in Fig. 3.
Fig. 5 is an enlarged schematic sectional view in which the region in the vicinity of a protective film 2 in Fig. 4 is enlarged.
Figs. 6A to 6C are schematic sectional views showing specific constitutions of first solid particle 2a according to the fourth embodiment of the invention.
Fig. 7 is a perspective view showing one example of a crucible for melting silicon according to a fifth embodiment of the invention.
Fig. 8 is a sectional view of A-A direction in Fig. 7.
Fig. 9 is an enlarged schematic sectional view in which the region in the vicinity of a protective film 22 in Fig. 8 is enlarged.
Figs. 10A to 10C are schematic sectional views showing specific constitutions of solid particle 22a according to the fifth embodiment of the invention.

### Description of Reference Numerals and Signs

10: Crucible for melting silicon
12: Crucible main body
14: Protective film
1: Crucible main body
2: Protective film
3: Interface
21: Crucible main body
22: Protective film
22a: Solid particle

### BEST MODE FOR CARRYING OUT THE INVENTION

The embodiment of the present invention is described in detail below.

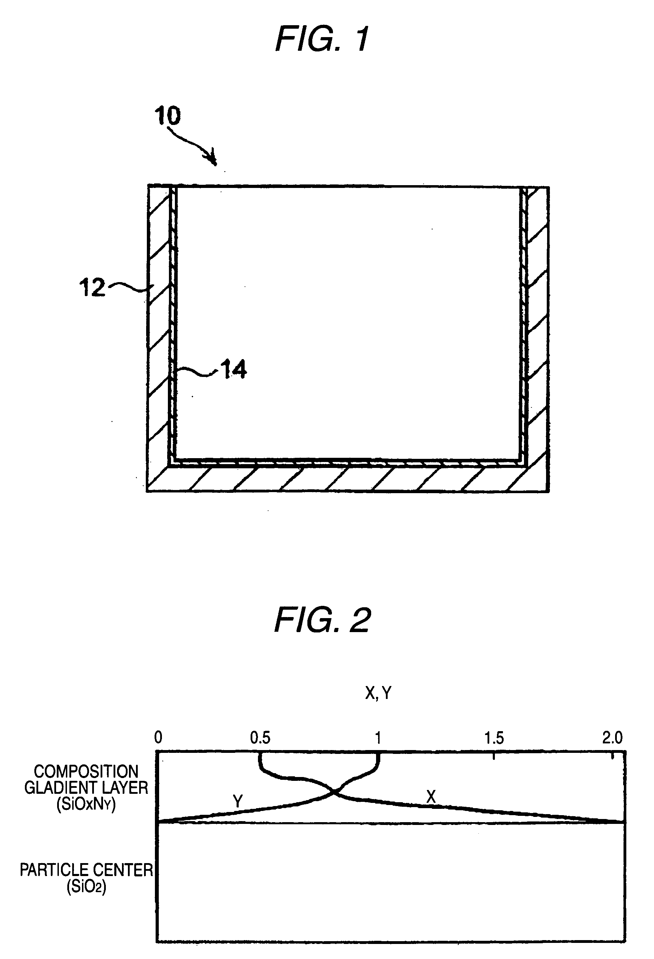

Fig. 1 is a sectional view showing a schematic structure of a crucible for melting silicon according to first to third embodiments of the invention.

### (First Embodiment)

A crucible 10 for melting silicon according to this embodiment has a structure including a crucible main body 12 including a heat-resistant member, and formed on at least an inner surface of the crucible main body 12 a protective film 14 containing a silicon oxynitride having a compositional formula of SiO_{X}N_{Y} (X > 0 and Y > 0). Quartz is preferably used as the material for the heat-resistant member used herein.

The quartz used as the material for the heat-resistant member includes not only quartz glass but fused quartz.

It should be understood that the quartz used herein is constituted of a dense body.

SiO_{X}N_{Y} (X>0 and Y>0) is difficult to get wet with molten silicon as compared with SiO₂ and Si₃N₄. Therefore, a silicon block obtained by solidifying molten silicon on the inner surface of the crucible 10 for melting silicon does not adhere to the crucible 10 for melting silicon, and is easily demolded from the crucible 10 for melting silicon and can be taken out of the crucible.

A method for producing the crucible for melting silicon according to the embodiment by forming the protective film 14 on the crucible main body 12 is described below.

The protective film 14 is formed using a powder which is an aggregate of silica (SiO₂) fine particles of high purity (for example, purity: 99.9% or more) as a raw material. The powder is nitrided for producing a powder of fine particles having on at least the surface thereof a single composition of SiO_{X}N_{Y} (X > 0 and Y > 0), and this powder is used as a release agent. The "single composition" used herein means one kind of SiO_{X}N_{Y} (X > 0 and Y > 0) composition defined by one pair of X and Y.

For example, in the case using a VAD method (Vapor-phase Axial Deposition Method) widely used as a method for producing a porous suite for optical fiber, the high purity silica fine particles can be formed by reacting a raw material in acid-hydrogen flame from a burner. The silica fine particles thus produced contain extremely small amount of impurities, and is preferred as a raw material for the formation of a protective film.

Silica fine particles used as a raw material are not limited to the silica fine particles produced by the above method. For example, dry silica can be sued. Silica fine particle is a material widely used in a production apparatus of a semiconductor device, and there are various technologies for synthesizing it in high purity. Therefore, high-purity silica fine particles can relatively easily be obtained.

As the nitriding treatment of the silica fine particles, at least the surface of the silica fine particles can be nitrided by conducting heat treatment at high temperature for a given period of time in a nitrogenous gas-containing atmosphere (for example, in a mixed gas atmosphere of hydrogen gas and ammonia).

Silica fine particles having different degree of nitridation, that is, SiO_{X}N_{Y} powder, can be obtained by controlling treatment conditions (for example, heat treatment time) of the nitriding treatment.

The formation of the protective film 14 on the inner surface of the crucible main body 12 can be conducted as follows.

First, a suspension is prepared using a SiO_{X}N_{Y} powder as a release agent, pure water and a binder (for example, polyvinyl alcohol (PVA)). The suspension is sprayed to, for example, the inner surface of a concave crucible main body 12, and then dried. The spray coating and drying are repeated until the coating film has a desired thickness.

Subsequently, the crucible main body 12 having the coating film formed thereon is heated to a given temperature to burn the same. At that time, the binder (for example, PVA) is gasified (burned) in the temperature-rising process. Furthermore, it is preferred that SiO_{X}N_{Y} fine particles are burned and welded with each other in a state that a certain amount of pores remain in the inside of the coating film so as not to generate the state that the SiO_{X}N_{Y} fine particles melt and droop down by the action of gravity to cause sliding down of the film or the change in film thickness. In this manner, protective film 14 closely adhered to the crucible main body 12 can be formed.

The crucible for melting silicon according to this embodiment can be obtained by the above-described production method. Therefore, the protective film is easily formed on a crucible main body without the necessity of post-treatment such as polishing, or CVD method. As a result, production economy is good and a crucible can be produced at low cast.

Furthermore, the crucible for melting silicon according to this embodiment may be produced by preparing a plurality of plate-like materials (not shown) including a heat-resistant member, conducting the above-described spray coating, drying and burning to at least one surface of the respective plate-like materials to form the respective protective films 14, and combining the plurality of plate-like materials through joints such that at least a surface on which the protective film 14 is formed becomes the inner surface.

The protective film 14 formed by the above-described production method is constituted of a sintered body of a powder having a single composition of SiO_{X}N_{Y} (X > 0 and Y > 0). Thus, since the protective film 14 is constituted of a sintered body, the protective film 14 itself has high strength, and breakage (peeling) of the protective film 14 can be prevented.

Furthermore, since the crucible main body 12 is constituted of quartz, the protective film 14 constituted of SiO_{X}N_{Y} (X > 0 and Y > 0) has a thermal expansion coefficient near that of the crucible main body 12 as compared with the case of Si₃N₄, and generation of thermal stress due to compositional difference is suppressed. As a result, even in the case that rapid temperature gradient is generated between the crucible main body 12 and the protective film 14, destruction or peeling of the protective film 14 can be prevented, and a crucible for melting silicon having excellent durability can be obtained.

Furthermore, the protective film 14 is not required to be constituted of multilayer structure as conventional ones, but is constituted of a monolayer, that is, a single film, as shown in Fig. 1. Therefore, generation of problems due to the multilayer structure (for example, peeling between the layers laminated) can be prevented.

It is preferred that the above SiO_{X}N_{Y} composition satisfies 0.2 ≤ X ≤ 0.8 and 0.8 ≤ Y ≤ 1.2. The preferred ranges of X and Y in the SiO_{X}N_{Y} composition are described together when describing the Examples described hereinafter.

Furthermore, the protective film 14 may be a film having such a gradient composition that Y is decreased and X is increased toward the depth direction (width direction of the protective film 14) from the surface thereof.

That is, the protective film 14 may be not only a film in which the interface of the protective film 14 contacting with the inner surface of the crucible main body 12 may be SiO₂ (X = 2 and Y = 0) which is a composition free of nitrogen, but also a film in which the surface of the protective film 14 is SiO_{X}N_{Y} (X > 0 and Y > 0), and Y (nitrogen concentration) is decreased and X (oxygen concentration) is increased toward the depth direction of the protective film 14 from the surface of the protective film 14 (this film may be hereinafter referred to as a "composition gradient film").

When the composition gradient film is formed at least on the inner surface of the crucible main body 12 constituted of quartz or fused quartz, generation of thermal stress due to compositional difference is further suppressed. As a result, destruction and peeling of the protective film 14 are further effectively prevented, and a crucible for melting silicon having further excellent durability can be obtained.

Similarly, since the composition gradient film is not constituted of the multilayer structure as conventional ones, but is constituted of a single film of a composition gradient film, generation of problems due to the multilayer structure (for example, peeling between the layers laminated) can be prevented.

The composition gradient film can be obtained by preparing sprays employing SiO_{X}N_{Y} powders having different degrees of nitridation, conducting a coating with a spray containing a SiO_{X}N_{Y} powder having a smaller degree of nitridation, followed by drying, and successively conducting a coating with a spray containing a SiO_{X}N_{Y} powder having a larger degree of nitridation, followed by drying. In this case, coating with a spray containing a SiO_{X}N_{Y} powder having a degree of nitridation of zero may first be conducted.

The composition gradient film can also be formed by the following method.

That is, the film can be formed by burning a crucible having a coating film formed to a given thickness with a spray containing silica (SiO₂) fine particles which are not subjected to nitriding treatment, at low temperature for a short period of time in a nitrogenous gas-containing atmosphere (for example, a mixed gas atmosphere of hydrogen gas and ammonia).

It is preferred that the protective film 14 contains alkali metal, alkali earth metal, fluoride, chloride, carbon, iron, chromium, cobalt, nickel, tungsten, molybdenum and titanium as impurities at a total concentration of 100 ppm or less. Accordingly, dissolution of impurities into a silicon melt is suppressed, and high quality silicon crystal can be obtained.

The concentration standard of impurities in the protective film 14 can be achieved by using SiO_{X}N_{Y} (X > 0 and Y > 0) powder obtained by nitiding the above-described high-purity silica (SiO₂) fine particles as a raw material.

### (Second Embodiment)

A second embodiment of the invention is described in detail below.

The crucible for melting silicon according to this embodiment differs from that of the first embodiment in that fine particles constituting the release agent used for the formation of the protective film 14 have a composition gradient in which X and Y are changed as described above. Other elements are the same as in the first embodiment, and therefore, the descriptions regarding those are omitted.

The release agent used in this embodiment is a powder having, at least on the surface thereof, a composition of SiO_{X}N_{Y} in which X > 0 and Y > 0, in which the powder is an aggregate of fine particles having such a composition gradient that Y is decreased and X is increased toward the depth direction thereof from the surface thereof.

The release agent can be formed by burning the above-described high-purity silica fine particles in a nitrogenous gas-containing atmosphere (for example, in a mixed gas atmosphere of hydrogen gas and ammonia) at the same temperature as in the first embodiment or a temperature lower than the temperature for the same period of time as in the first embodiment or a period of time shorter than the period of time.

The crucible for melting silicon according to this embodiment can be prepared in the same manner as described in the first embodiment. That is, using a release agent constituted of fine particles having the composition gradient, a suspension is prepared together with pure water and a binder (for example, polyvinyl alcohol (PVA)). The suspension is sprayed to the inner surface of the crucible main body 12, and then dried to form a coating film. Subsequently, the crucible main body 12 having the coating film formed thereon is heated to a given temperature to burn the same, thereby forming the protective film 14. Thus, the crucible can be produced. In this case, similarly as the first embodiment, it is preferred that SiO_{X}N_{Y} fine particles are burned and welded with each other in a state that a certain amount of pores remain in the inside of the coating film so as not to generate the state that the SiO_{X}N_{Y} fine particles melt and droop down by the action of gravity to cause sliding down of the film or the change in film thickness. Thus, the protective film 14 closely adhered to the crucible main body 12 can be formed.

The protective film 14 formed by the above-described production method is constituted of a sintered body of a powder having a composition of SiO_{X}N_{Y} (X > 0 and Y > 0), and the powder is an aggregate of fine particles having such a composition gradient that Y is decreased and X is increased toward the depth direction thereof from the surface thereof.

Thus, since the protective film 14 is constituted of a sintered body, the protective film 14 itself has high strength, and breakage (peeling) of the protective film 14 can be prevented.

Furthermore, since the crucible main body 12 is constituted of quartz, the protective film 14 constituted of SiO_{X}N_{Y} (X > 0 and Y > 0) has a thermal expansion coefficient near that of the crucible main body 12 as compared with the case of Si₃N₄, and generation of thermal stress due to compositional difference is suppressed. As a result, even in the case that rapid temperature gradient is generated between the crucible main body 12 and the protective film 14, destruction or peeling of the protective film 14 can be prevented, and a crucible for melting silicon having excellent durability can be obtained.

Furthermore, since the protective film 14 constituting the crucible for melting silicon according to this embodiment is constituted of a sintered body of an aggregate (powder) of fine particles having such a composition gradient that Y is decreased and X is increased toward the depth direction thereof from the surface thereof, the thermal expansion coefficient thereof is close to that of quartz glass while exhibiting releasability equal to that of the protective film of the first embodiment constituted of fine particles having a single composition. Therefore, in the case of using the protective film for a quartz-made crucible, breakage and peeling of the protective film 14 can further be prevented.

### (Third Embodiment)

A third embodiment of the invention is described in detail below.

The crucible for melting silicon according to this embodiment differs from the first embodiment in that the protective film 14 is a dense body. Other elements are the same as in the first embodiment, and therefore, the descriptions regarding those are omitted.

The crucible for melting silicon according to this embodiment can be produced by the following method.

The crucible can be formed by burning the crucible main body 12 as a dense body constituted of quartz (SiO₂) at high temperature for a given period of time in a nitrogenous gas-containing atmosphere (for example, in a mixed gas of hydrogen gas and ammonia). Accordingly, the protective film 14 which is a dense body having the composition of SiO_{X}N_{Y} (X > 0 and Y > 0) can be formed on the surface of the crucible main body 12.

By appropriately setting a mixing ratio of a nitrogen type gas in the nitrogenous gas-containing atmosphere, treatment temperature, treatment time and the like, the protective film 14 which is a dense body can appropriately designed to a protective film having a single composition of SiO_{X}N_{Y} (X > 0 and Y > 0), or a protective film having such a composition gradient that Y is decreased and X is increased toward the depth direction thereof from the surface thereof as described above.

Thus, in the crucible for melting silicon according to this embodiment, the protective film 14 is constituted a dense body as with the crucible main body 12. That is, the protective film 14 is formed not as a coating film but as one layer on the surface layer of at least the inner surface of the crucible main body 12 which is a dense body. Therefore, the protective film 14 is free from destruction and peeling, and the crucible for melting silicon having excellent durability can be obtained.

### (Fourth Embodiment)

A fourth embodiment of the invention is described in detail below.

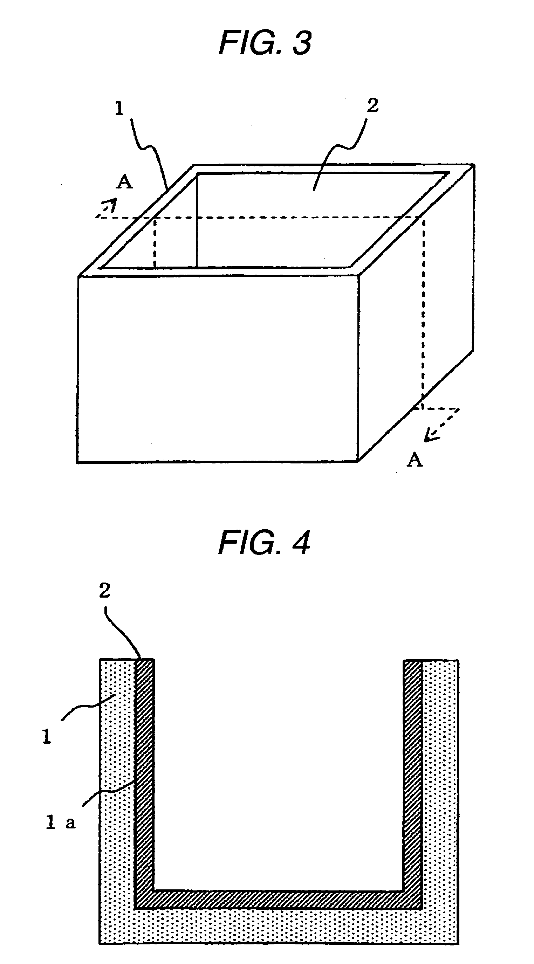

Fig. 3 is a perspective view showing one example of the crucible for melting silicon according to the fourth embodiment of the invention, and Fig. 4 is a sectional view in A-A direction of Fig. 3.

The crucible for melting silicon according to this embodiment is provided with a crucible main body 1, and a protective film 1 formed on the inner surface 1a of the crucible main body 1, as shown in Fig. 3 and Fig. 4.

The crucible main body 1 includes a heat-resistant member, and is constituted of, for example, an integrally-molded type crucible in which the whole thereof is integrally molded. Quartz is preferably used as the material for the heat-resistant member. The quartz includes not only quartz glass, but fused quartz.

The protective film 2 is constituted of a single layer formed on the inner surface 1a of the crucible main body 1, as shown in Fig. 4.

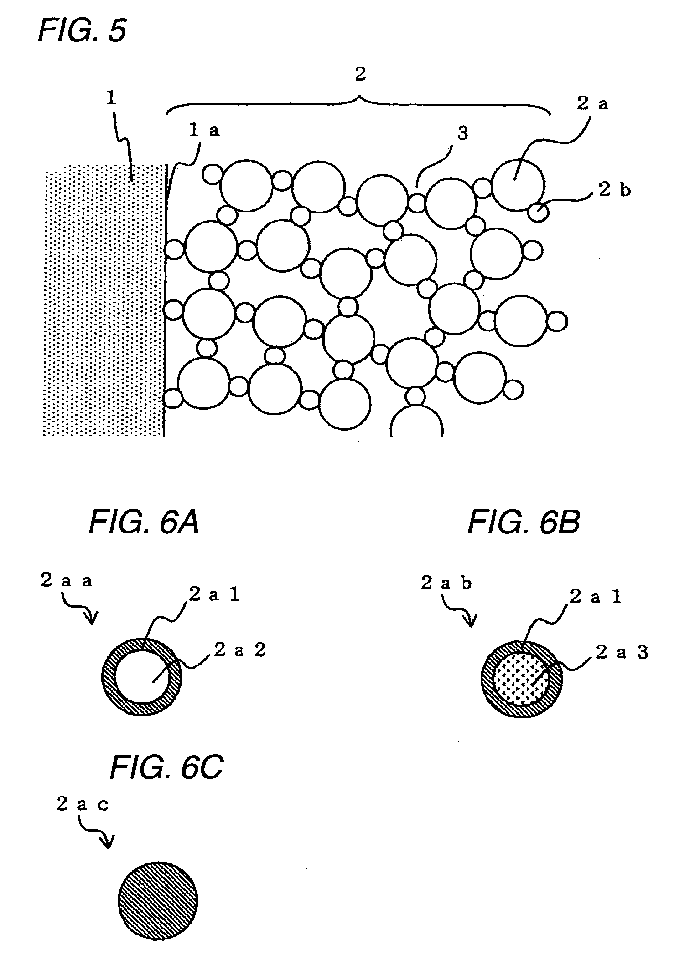

Fig. 5 is an enlarged schematic sectional view in which the region in the vicinity of a protective film 2 in Fig. 4 is enlarged. The view shown in Fig. 5 is a schematic view, and shape and size of solid particles and thickness of the protective film 2 formed by the solid particles shown in Fig. 5 differ from the actual sizes.

As shown in Fig. 5, the protective film 2 contains first solid particles 2a and second solid particles 2b having a particle diameter smaller than that of the first solid particles 2a, and the second solid particles 2b connect the first solid particles 2a with each other at a part of an interface 3 between the first solid particles 2a.

The first solid particle 2a has, on at least the surface thereof, a composition of SiO_{X}N_{Y} (X > 0 and Y > 0).

Figs. 6A to 6C are schematic sectional views showing specific constitutions of first solid particle 2a according to this embodiment.

Specifically, the first solid particle 2a is constituted of either a solid particle 2aa in which a surface layer 2a1 is constituted of SiO_{X}N_{Y} (X > 0 and Y > 0) and a core part 2a2 is constituted of silica (SiO₂), as shown in Fig. 6A; a solid particle 2ab in which a surface layer 2a1 is constituted of SiO_{X}N_{Y} (X > 0 and Y > 0) and a core part 2a3 is constituted of silicon nitride (Si₃N₄), as shown in Fig. 6B; or a solid particle 2ac in which the whole particle is constituted of SiO_{X}N_{Y} (X > 0 and Y > 0), as shown in Fig. 6C.

The second solid particle 2b is constituted of a solid particle having SiO₂ composition, that is, a silica particle.

The crucible for melting silicon according to this embodiment has the above-described constitution. Accordingly, the crucible is provided with a protective film having excellent releasability, that can suppress generation of crack and breakage of a silicon block due to adhesion between the protective film and the silicon block by the collapse of the protective film itself when demolding the silicon block from the crucible can be obtained.

That is, since the first solid particle 2a constituting the protective film of the crucible for melting silicon according to this embodiment has a SiO_{X}N_{Y} (X > 0 and Y > 0) composition at least on the surface thereof as described above, the first solid particle 2a has an effect that the particle is difficult to get wet with molten silicon as compared with SiO₂ and Si₃N₄. Furthermore, since the second solid particle 2b connects the first solid particles 2a with each other at a part of an interface 3 between the first solid particles 2a, the protective film 2 has high strength to an extent such that peeling between the first solid particles 2a is not generated. Additionally, since the second solid particle 2b connects the first solid particles 2a with each other, not at the whole, but at a part of the interface 3 between the first solid particles 2a, strength is decreased as compared with the case that the first solid particles 2a are connected with each other at the whole interface. Therefore, even if the second solid particle 2b or the first solid particle 2a present on the outermost surface of the protective film 2 is adhered to a silicon block, since the protective film 2 is first broken when demolding the silicon block from the crucible, generation of crack and breakage of the silicon block due to adhesion between the protective film 2 and the silicon block can be prevented.

The composition of SiO_{X}N_{Y} (X > 0 and Y > 0) at least on the surface of the first solid particle 2a satisfies, for example, 0.2 ≤ X ≤ 0.8 and 0.8 ≤ Y ≤ 1.2. The analysis of X and Y can be obtained by oxygen and nitrogen simultaneous analysis method.

Particle diameters of the first solid particle 2a and the second solid particle 2b and their and weight ratio are not particularly limited so long as the above-described protective film 2 can be formed. The particle diameter of the first solid particle 2a is, for example, from 100 to 1,000 nm, and the particle diameter of the second solid particle 2b is, for example, from 1 to 10 nm. The weight ratio of the second solid particle 2b to the first solid particle 2a is, for example, from 0.1 to 5 wt%.

The release agent according to this embodiment is constituted of a material that can provide the above-described protective film 2. That is, the release agent according to this embodiment is constituted of a powder containing the first solid particles having, at least on the surface thereof, a composition of SiO_{X}N_{Y} (X > 0 and Y > 0); and the second solid particles 2b having a composition of SiO₂ and having a particle diameter smaller than that of the first solid particles 2a.

By using the release agent having such a constitution, the crucible for melting silicon provided with the protective film having the above-described effects can be obtained.

A method for producing the crucible for melting silicon according to this embodiment by forming the protective film 2 on the crucible main body 1 is described below.

In the production of the first solid particle 2a used in the protective film 2, a powder which is an aggregate of silica fine particles of high purity (for example, purity: 99.9% or more) is used as a raw material, the powder is nitrided to produce a powder of solid particles (Figs. 6A and 6C) in which at least the surface thereof has SiO_{X}N_{Y} (X > 0 and Y > 0) composition, and the powder is used as a release agent. Alternatively, a powder which is an aggregate of silicon nitride fine particles of high purity (for example, purity: 99.9% or more) is used as a raw material, the powder is oxidized to produce a powder of solid particles (Figs. 6B and 6C) in which at least the surface thereof has SiO_{X}N_{Y} (X > 0 and Y > 0) composition, and the powder is used as a release agent (first solid particle 2a).

As the nitriding treatment of the silica fine particles, at least the surface of the silica fine particles can be nitrided by conducting heat treatment at high temperature (for example, 1,100°C) for a given period of time in a nitrogenous gas-containing atmosphere (for example, in a mixed gas atmosphere of hydrogen gas and ammonia gas). By controlling treatment conditions (for example, heat treatment time) of the nitriding treatment, silica fine particles having different degrees of nitridation, that is, SiO_{X}N_{Y} powder, can be obtained. Furthermore, by further prolonging the heat treatment time, solid particles (Fig. 6C) in which the whole particle is constituted of SiO_{X}N_{Y} (X > 0 and Y > 0) can be produced.

As the oxidizing treatment of the silicon nitride fine particles, at least the surface of the silicon nitride fine particles can be oxidized by conducting heat treatment at high temperature (for example, 800°C) for a given period of time in an oxidizing gas-containing atmosphere (for example, air atmosphere). By controlling treatment conditions (for example, heat treatment time) of the oxidizing treatment, silicon nitride fine particles having different degrees of oxidation, that is, SiO_{X}N_{Y} powder, can be obtained. Furthermore, by further prolonging the heat treatment time, solid particles (Fig. 6C) in which the whole particle is constituted of SiO_{X}N_{Y} (X > 0 and Y > 0) can be produced.

Incidentally, in the case that an oxide film SiO₂ (X = 2 and Y = 0) is formed on the surface of solid fine particles by the oxidizing treatment, the oxide film can be removed by conducting a treatment using dilute HF.

A powder of silica fine particles of high purity (for example, purity: 99.9% or more) having a particle diameter smaller than that of the first solid particle 2a is used for the second solid particle 2b used in the protective film 2.

Formation of the protective film 2 on the inner surface 1a of the crucible main body 1 is conducted as follows.

First, a suspension is prepared using the first solid particles 2a in which at least the surface thereof is constituted of SiO_{X}N_{Y} (X > 0 and Y > 0), the second solid particles 2b having SiO₂ composition and having a particle diameter smaller than that of the first solid particles 2a, pure water and a binder (for example, polyvinyl alcohol (PVA)). The suspension is sprayed to, for example, the inner surface 1a of a concave crucible main body 1, and then dried. The spray coating and drying are repeated until the coating film has a desired thickness.

Subsequently, the crucible main body 1 having the coating film formed thereon is heated to a given temperature (for example, 800°C) in a non-oxidizing atmosphere (for example, in an argon atmosphere) to burn the same.

At this time, the binder (for example, PVA) is gasified (burned) in the temperature-rising process. Furthermore, it is preferred that the solid particles are burned and welded with each other in a state that a certain amount of pores remain in the inside of the coating film so as not to generate the state that the solid particles melt and droop down by the action of gravity to cause sliding down of the film or the change in film thickness. Thus, the protective film 2 closely adhered to the crucible main body 1 can be formed.

The crucible for melting silicon according to this embodiment can be obtained by the above-described production method. Therefore, the protective film is easily formed on a crucible main body without the necessity of post-treatment such as polishing, or CVD method. As a result, production economy is good and a crucible can be produced at low cast.

The crucible main body 1 is described above by reference to an integrally-molded type crucible, but the invention is not limited to the embodiment, and a partition-type crucible may be used. In the case that a partition-type crucible is produced as the crucible for melting silicon according to this embodiment, the crucible can be produced by preparing a plurality of plate-like material (not shown) including a heat-resistant member, conducting the above-described spray coating, drying and burning at least on one surface of the plate-like materials to form the respective protective films 14, and combining the plurality of plate-like materials through joints or the like such that at least a surface on which the protective film is formed becomes the inner surface when a crucible shape is formed.

It is preferred that the crucible main body is constituted of quartz.

Owing to such a constitution, the first solid particle 2a and the second solid particle 2b have a thermal expansion coefficient near or equal to that of the crucible main body 1 as compared with other materials, and generation of thermal stress due to compositional difference is suppressed. As a result, even in the case that thermal shock or physical shock is generated on the crucible for melting silicon, destruction and peeling of the protective film 2 can be prevented.

### (Fifth Embodiment)

A fifth embodiment of the invention is described in detail below.

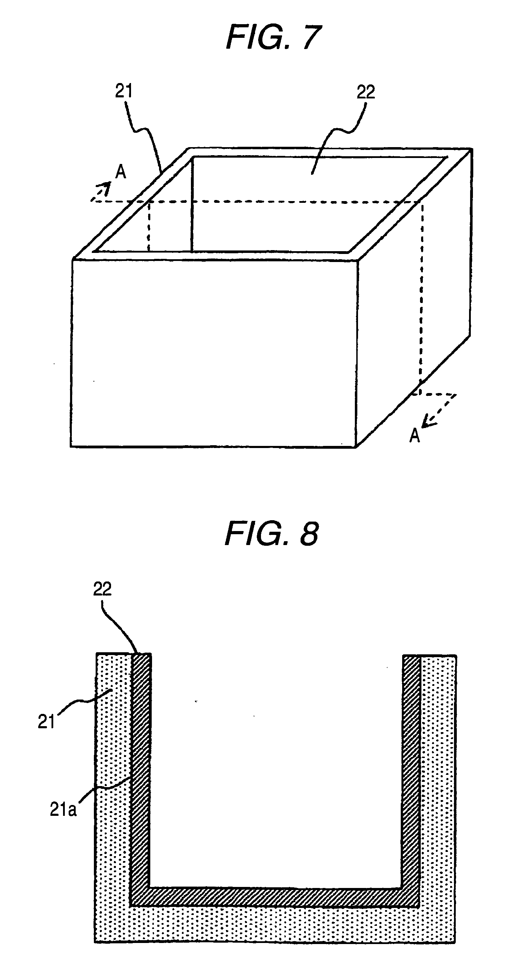

Fig. 7 is a perspective view showing one example of a crucible for melting silicon according to the fifth embodiment of the invention. Fig. 8 is a sectional view in A-A direction of Fig. 7.

As shown in Fig.7 and Fig. 8, the crucible for melting silicon according to this embodiment is provided with a crucible main body 21 and a protective film 21 formed on an inner surface 21a of the crucible main body 21.

The crucible main body 21 includes a heat-resistant member, and, for example, is constituted of an integrally-molded type crucible in which the whole crucible is integrally molded, as shown in Fig. 7. Quartz is preferably used as the material for the heat-resistant member. The quart includes not only quartz glass, but fused quartz.

As shown in Fig. 8, the protective film 22 is constituted of a single layer formed on the inner surface 21 a of the crucible main body 21.

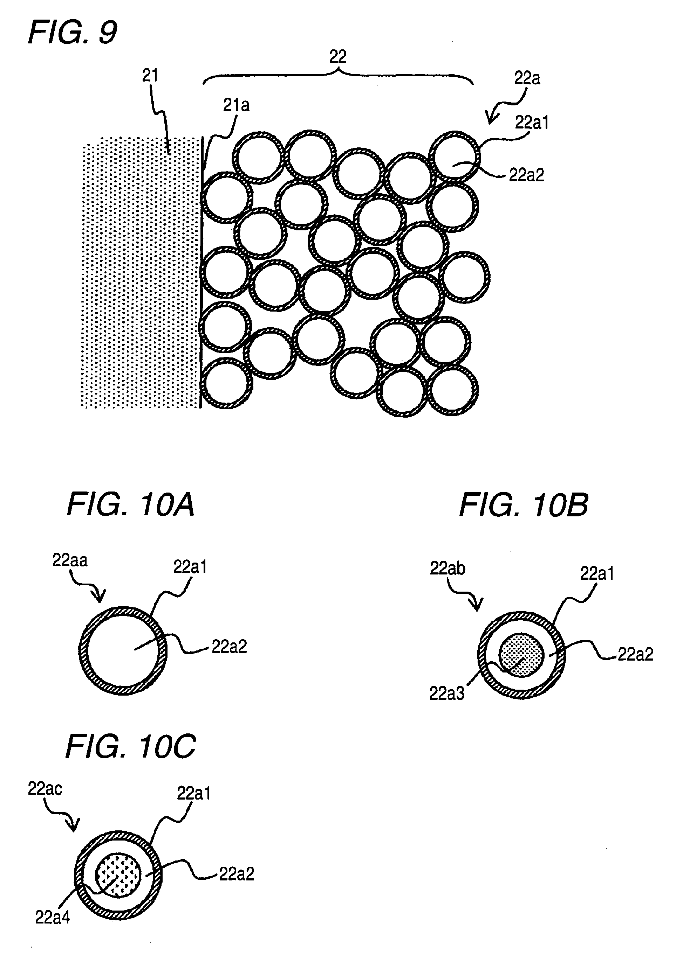

Fig. 9 is an enlarged schematic sectional view in which the region in the vicinity of a protective film 22 in Fig. 8 is enlarged. The view shown in Fig. 9 is a schematic view, and shape and size of solid particles and thickness of the protective film 22 formed by the solid particles shown in Fig. 9 differ from the actual sizes.

As shown in Fig. 9, the protective film 22 contains a plurality of solid particles 22a, and has such a constitution that an oxide film 22a1 is formed on the surface of each solid particle 22a and the solid particles 22a are connected with each other through the oxide film 22a1.

The portion located at a direct inner layer 22a2 (inner layer directly contacting with the oxide film 22a1 of the solid particle 22a) of the oxide film 22a1 of the solid particle 22a has a composition of SiO_{X}N_{Y} (X > 0 and Y > 0).

Figs. 10A to 10C are schematic sectional views showing specific constitutions of the solid particle 22a according to this embodiment.

Specifically, the solid particle 22a is constituted of either a solid particle 22aa in which the oxide film 22a1 is formed on the surface thereof and the whole direct inner layer 22a2 of the oxide film 22a1 has SiO_{X}N_{Y} (X > 0 and Y > 0) composition as shown in Fig. 10A; a solid particle 22ab in which the oxide film 22a1 is formed on the surface thereof, a composition layer having SiO_{X}N_{Y} (X > 0 and Y > 0) composition is formed as the direct inner layer 22a2 of the oxide film 22a1, and the core part 22a3 is silica (SiO₂) as shown in Fig. 10B; or a solid particle 22ac in which the oxide film 22a1 is formed on the surface thereof, a composition layer having SiO_{X}N_{Y} (X > 0 and Y > 0) composition is formed as the direct inner layer 22a2 of the oxide film 22a1 and the core part 22a4 is silicon nitride (Si₃N₄) as shown in Fig. 10(c).

The crucible for melting silicon according to this embodiment has the above-described constitution. Therefore, the crucible has the protective film which does not peel even in the case that thermal shock or physical shock is generated, and has excellent releasability.

That is, since the solid particle constituting the protective film of the crucible for melting silicon according to this embodiment is such that the oxide film is formed on the surface thereof and the direct inner layer of the oxide film has SiO_{X}N_{Y} (X > 0 and Y > 0) composition as described above, the solid particles can strongly be connected with each other by the oxide film formed on the surface thereof. Furthermore, since SiO_{X}N_{Y} (X > 0 and Y > 0) is an intermediate between SiO₂ and Si₃N₄, the intermediate has a thermal expansion coefficient close to that of the oxide film (SiO₂), and as a result, the oxide film formed on the surface can be prevented from being peeled. Furthermore, even if the oxide film formed on the surface is peeled in the case that thermal shock or physical shock is generated, since the portion exposed is a layer of SiO_{X}N_{Y} (X > 0 and Y > 0) composition and this portion is difficult to get wet with fused silicon, releasability of the crucible for melting silicon does not become a problem.

Furthermore, in the case that the solid particle 22ac is used and thermal shock or physical shock is generated, even if the oxide film 22a1 on the surface is peeled, the exposed SiO_{X}N_{Y} (X > 0 and Y > 0) composition is an intermediate between SiO₂ and Si₃N₄ as described above, and the intermediate has a thermal expansion coefficient close to that of Si₃N₄. Therefore, the SiO_{X}N_{Y} (X > 0 and Y > 0) composition can be prevented from being peeled, and as a result, the protective film is free from exposure of silicon nitride of the core part 22a4 of the solid particle 22ac, and breakage of the solid particle 22ac can be prevented.

The SiO_{X}N_{Y} (X > 0 and Y > 0) composition of the solid particle 22a satisfies, for example, 0.2 ≤ X ≤ 0.8 and 0.8 ≤ Y ≤ 1.2. X and Y can be obtained by oxygen and nitrogen simultaneous analysis method.

A particle diameter of the solid particle 22a is not particularly limited so long as the above-described protective film 22 can be formed. The particle size of the solid particle 22a is, for example, from 100 to 1,000 nm.

Furthermore, a thickness of the oxide film a1 is, for example, 1 to 5 nm.

The release agent according to this embodiment is constituted of a material that can provide the above-described protective film 22. That is, the release agent according to this embodiment is constituted of a powder containing a plurality of solid particles in which an oxide film is formed on the surface thereof and a direct inner layer of the oxide film has a composition of SiO_{X}N_{Y} (X > 0 and Y > 0).

By using the release agent having the constitution, the crucible for melting silicon provided with the protective film having the above-described effects can be obtained.

A method for producing the crucible for forming silicon according to this embodiment by forming the protective film on the crucible main body 21 is described below.

For the formation of the protective film 22, a powder which is an aggregate of silica fine particles of high purity (for example, purity: 99.9% or more) is used as a raw material, the raw material is nitrided, followed by oxidizing treatment, thereby producing a powder of solid particles (Figs. 10A and 10B) in which an oxide film is formed on the surface thereof and a direct inner layer of the oxide film has SiO_{X}N_{Y} (X > 0 and Y > 0) composition, and the powder is used as a release agent (solid particle). Alternatively, a powder which is an aggregate of silicon nitride fine particles of high purity (for example, purity: 99.9% or more) is used as a raw material, the raw material is oxidized, thereby producing a powder of solid particles (Figs. 10A and 10C) in which an oxide film is formed on the surface thereof and a direct inner layer of the oxide film has SiO_{X}N_{Y} (X > 0 and Y > 0) composition, and the powder is used as a release agent (solid particle).

As the nitriding treatment of the silica fine particles, at least the surface of the silica particles can be nitrided by conducting heat treatment at high temperature (for example, 1,100°C) for a given period of time in a nitrogenous gas-containing atmosphere (for example, mixed gas atmosphere of hydrogen gas and ammonia gas). The subsequent oxidizing treatment can form an oxide film on the nitrided surface by conducting heat treatment at high temperature (for example, 800°C) for a given period of time in an oxidizing gas-containing atmosphere (for example, air atmosphere). By controlling treatment conditions (for example, heat treatment time) at the time of the nitriding treatment, SiO_{X}N_{Y} (X > 0 and Y > 0) compositions having different degrees of nitridation can be obtained. Furthermore, by further prolonging the heat treatment time in the nitriding treatment, solid particles (Fig. 10A) in which the whole direct inner layer of the oxide film is constituted of SiO_{X}N_{Y} (X > 0 and Y > 0) can be produced.

As the oxidizing treatment of the silicon nitride fine particles, at least the surface of the silicon nitride fine particles can be oxidized by conducting heat treatment at high temperature (for example, 800°C) for a given period of time in an oxidizing gas-containing atmosphere (for example, air atmosphere), and at the same time, a layer having SiO_{X}N_{Y} (X > 0 and Y > 0) composition is formed on a direct inner layer of the oxide film. By controlling treatment conditions (for example, heat treatment time) of the oxidizing treatment, SiO_{X}N_{Y} compositions having different degrees of oxidation can be obtained. Furthermore, by further prolonging the heat treatment time in the oxidizing treatment, solid particles (Fig. 10A) in which the whole direct inner layer of the oxide film is constituted of SiO_{X}N_{Y} (X > 0 and Y > 0) can be produced. Furthermore, adjustment of a thickness of the oxide film can be conducted by controlling the heat treatment time in the oxidizing treatment.

Formation of the protective film 22 on the inner surface 21a of the crucible main body 21 can be conducted as follows.

First, a suspension is prepared using the solid particles in which the oxide film is formed on the surface thereof and the direct inner layer of the oxide film has SiO_{X}N_{Y} (X > 0 and Y > 0) composition, pure water and a binder (for example, polyvinyl alcohol (PVA)). The suspension is sprayed to, for example, the inner surface 21a of a concave crucible main body 21, and then dried. The spray coating and drying are repeated until the coating film has a desired thickness.

Subsequently, the crucible main body 21 having the coating film formed thereon is heated to a given temperature (for example, 800°C) in a non-oxidizing atmosphere (for example, an argon atmosphere) to burn the same. At this time, the binder (for example, PVA) is gasified (burned) in the temperature-rising process. Furthermore, it is preferred that the solid particles are burned and welded with each other in a state that a certain amount of pores remain in the inside of the coating film so as not to generate the state that the solid particles melt and droop down by the action of gravity to cause sliding down of the film or the change in film thickness. Thus, the protective film 22 closely adhered to the crucible main body 21 can be formed.

The crucible for melting silicon according to this embodiment can be obtained by the above-described production method. Therefore, the protective film is easily formed on a crucible main body without the necessity of post-treatment such as polishing, or CVD method. As a result, production economy is good and a crucible can be produced at low cast.

The crucible main body 21 is described above by reference to an integrally-molded type crucible, but the invention is not limited to the embodiment, and a partition-type crucible may be used. In the case that a partition-type crucible is used as the crucible for melting silicon according to this embodiment, the crucible can be produced by preparing a plurality of plate-like materials (not shown) including a heat-resistant member, conducting the above-described spray coating, drying and burning at least on one surface of the plate-like materials to form the respective protective films, and combining the plurality of the plate-like materials through joints or the like such that at least a surface on which the protective film becomes the inner surface side.

It is preferred that the crucible main body is constituted of quartz.

Owing to such a constitution, the solid particle 22a in which the surface thereof is constituted of the oxide film (SiO₂) and the crucible main body 21 have the same thermal expansion coefficient. Therefore, generation of thermal stress due to compositional difference is suppressed. As a result, even in the case that thermal shock or physical shock is generated in the crucible for melting silicon, destruction and peeling of the protective film 22 as a whole can be prevented.

### Examples

The first to third embodiments of the present invention are described in detail below by reference to the Examples.

### (Example 1: Formation of protective film of sintered body having single composition)

High-purity SiO₂ powder (purity is 99.9% or more; an average particle diameter formed by VAD method is 0.5 µm; and the total concentration of alkali metal, alkali earth metal, fluoride, chloride, carbon, iron, chromium, cobalt, nickel, tungsten, molybdenum and titanium is 2 ppm) was held at from 900 to 1,400°C for from about 30 minutes to 10 hours in a mixed gas atmosphere in which hydrogen and ammonia is adjusted to from 1:1 to 1.5 in volume ratio to prepare respective SiO_{X}N_{Y} powders having different degrees of nitridation.

A suspension was prepared using each SiO_{X}N_{Y} powder thus obtained, pure water and PVA.

Each suspension thus prepared was sprayed to an inner surface of a fused quartz-made crucible main body having an inner volume of 678 mm x 678 mm x 400 mm, and dried. The spray coating and drying were repeated until the film thickness reaches 500 µm. Thus, a coating film was formed. Furthermore, a coating film was formed on the surface of a fused quartz-made plate-like material having 100 mm x 100 mm x 10 mm as for composition evaluation of a protective film under the same conditions as above.

The crucible and plate-like material, having the coating film thus formed thereon were held in an air atmosphere at from 600 to 1,000°C for from 30 to 120 minutes such that SiO_{X}N_{Y} fine particles were welded with each other in a state that given pores remained in the inside of the coating film, thereby forming a protective film. Thus, plural crucibles and plate-like materials each having formed thereon SiO_{X}N_{Y} protective film having different degree of nitridation were prepared.

### (Evaluation method of composition of protective film)

The composition of the protective film formed into a plate-like material was analyzed with oxygen and nitrogen simultaneous analysis method to obtain X and Y. Furthermore, X-ray diffraction pattern of SiO_{X}N_{Y} was measured using a powder X-ray diffractometer.

### (Evaluation method of wettability to silicon: silicon melting and coagulation test)

Using the crucible prepared, fused silicon was introduced into the crucible up to a depth of about 300 mm, and solidified by cooling. The sample that crucible pieces could be removed from a silicon block thus prepared without difficulty was evaluated "A", the sample that crucible pieces could be removed in a state that slight cracks were generated in the finally solidified portion of the silicon block was evaluated "B", and the sample that the silicon block and the crucible were adhered over a wide area, crucible pieces could not easily be removed and considerable breakages were generated in the silicon block was evaluated "C".

### (Evaluation Results)

Evaluation results of the composition of the protective film formed and wettability between the protective film formed and silicon are shown in Table 1 according to the compositional analysis result.

**TABLE 1**

| SiO_{X}N_{Y} | | | | | | | | | | | | | |
|---|---|---|---|---|---|---|---|---|---|---|---|---|---|
| | | X | | | | | | | | | | | |
| | | 0 | 0.1 | 0.2 | 0.3 | 0.4 | 0.5 | 0.6 | 0.7 | 0.8 | 1 | 1.5 | 2 |
| Y | 1.3 | C | B | | | | | | | | | | |
| | 1.2 | | B | B | B | B | | | | | | | |
| | 1.1 | | C | B | A | A | A | A | | | | | |
| | 1 | | | | B | A | B | A | A | | | | |
| | 0.9 | | | | | A | A | A | A | B | | | |
| | 0.8 | | | | | | | | A | A | C | | |
| | 0.7 | | | | | | | | C | B | B | | |
| | 0.6 | | | | | | | | | | B | | |
| | 0.3 | | | | | | | | | | | B | |
| | 0 | | | | | | | | | | | | C |

| | | | | | | | | | | | | | |
|---|---|---|---|---|---|---|---|---|---|---|---|---|---|
| Evaluation A: Good Evaluation B: Feasible Evaluation C: Infeasible | | | | | | | | | | | | | |

The composition analysis results described here are the average value measured by simultaneous oxygen and nitrogen analysis method. As shown in Table 1, it is understood that the composition of the protective film in which excellent releasability is obtained satisfies 0.2 ≤ X ≤ 0.8 and 0.8 ≤ Y ≤ 1.2, and preferably 0.4 ≤ X ≤ 0.7 and 0.8 ≤ Y ≤ 1.1. In the samples having the evaluations "A" and "B", as a result of X-ray diffraction, a peak showing silicon nitride (Si₃N₄) was not detected. From this fact, it is considered that good releasability can be obtained owing to the state of an oxynitride film.

### (Example 2: Formation of composition gradient film)

A suspension was prepared using high-purity SiO₂ powder (purity is 99.9% or more; an average particle diameter formed by VAD method is 0.5 µm; and the total concentration of alkali metal, alkali earth metal, fluoride, chloride, carbon, iron, chromium, cobalt, nickel, tungsten, molybdenum and titanium is 2 ppm), pure water and PVA.

The suspension was sprayed to an inner surface of a fused quartz-made crucible main body having an inner volume of 678 mm x 678 mm x 400 mm, and dried. The spray coating and drying were repeated until the film thickness reaches 500 µm. Thus, a coating film was formed. Furthermore, a coating film was formed on the surface of a fused quartz-made plate-like material having 100 mm x 100 mm x 10 mm as for composition evaluation of a protective film under the same conditions as above.

The crucible and plate-like material, having the coating film thus formed thereon were held in a mixed gas atmosphere in which hydrogen and ammonia were adjusted to 1:5 in volume ratio, at 1,100°C for 5 hours such that SiO_{X}N_{Y} fine particles were welded with each other in a state that certain pores remained in the inside of the coating film, and Y was decreased and X was increased toward its depth direction from the surface, thereby converting the coating film into a composition gradient film. As a result of X-ray diffraction, a peak showing silicon nitride (Si₃N₄) was not detected in the composition gradient film.

As a comparative example, a crucible and a plate-like material, provided with a composition gradient film in which the surface thereof is Si₃N₄, that is, a peak showing Si₃N₄ is detected as a result of X-ray diffraction, were prepared by adjusting the treatment time.

### (Evaluation results)

As a result that the protective films formed by the above methods were evaluated in the same method as in Example 1, the sample having a composition gradient film in which a peak showing Si₃N₄ was not detected had the evaluation "A", and excellent releasability was obtained. However, the sample in which a peak showing Si₃N₄ was detected had the evaluation "C", and considerable breakage was generated in the silicon block.

### (Example 3: Formation of composition gradient fine particle and its evaluation)

High-purity SiO₂ powder (purity is 99.9% or more; an average particle diameter formed by VAD method is 0.5 µm; and the total concentration of alkali metal, alkali earth metal, fluoride, chloride, carbon, iron, chromium, cobalt, nickel, tungsten, molybdenum and titanium is 2 ppm) was held at 1,100°C for from 5 hours in a mixed gas atmosphere in which hydrogen and ammonia were adjusted to 1:5 in volume ratio to prepare a composition gradient SiO_{X}N_{Y} powder in which the degree of nitridation is decreased from the surface to the inside.

Compositions of oxygen and nitrogen on a superficial layer of the powder sample obtained and the face cut with every 10 nm depth from the superficial layer by Ar sputtering were examined by Auger electron spectroscopy, and the results obtained are shown in Fig. 2. As shown in Fig. 2, it was confirmed that the composition gradient SiO_{X}N_{Y} powder in which the ratios of oxygen and nitrogen were changed in a depth direction of the powder could easily be formed.

### (Example 4: Formation of protective film using composition gradient fine particle and its evaluation)

A suspension prepared in the same manner as in Example 1 using the fine particles having different degree of nitridation prepared in Example 3 was sprayed to an inner surface of a fused quartz-made crucible main body having an inner volume of 678 mm x 678 mm x 400 mm, and dried. The spray coating and drying were repeatedly conducted until the film thickness reaches 500 µm, thereby forming a coating film. Furthermore, for the evaluation of composition of a protective film, a coating film was formed on the surface of a fused quartz-made plate-like material having 100 mm x 100 mm x 10 mm under the same conditions as above.

The crucible and plate-like material, having the coating film thus formed thereon were held in an air atmosphere at from 600 to 1,000°C for from 30 to 120 minutes such that SiO_{X}N_{Y} fine particles were welded with each other in a state that given pores remain in the inside of the coating film, thereby forming a protective film. Thus, plural crucibles and plate-like materials each having formed thereon SiO_{X}N_{Y} protective film having different degree of nitridation were prepared.

### (Evaluation results)

Regarding the protective films formed by the above methods, the composition of the protective film and wettability between the protective film formed and silicon were evaluated. The evaluation results on the composition of the protective film formed and wettability between the protective film formed and silicon are shown in Table 2 according to the composition analysis result.

**TABLE 2**

| SiO_{X}N_{Y} | | | | | | | | | | | | | | |
|---|---|---|---|---|---|---|---|---|---|---|---|---|---|---|
| | | X | | | | | | | | | | | | |
| | | 0.0 | 0.5 | 1.0 | 1.1 | 1.2 | 1.3 | 1.4 | 1.5 | 1.6 | 1.7 | 1.8 | 1.9 | 2.0 |
| Y | 1.3 | C | | | | | | | | | | | | |
| | 1 | | | | | | | | | | | | | |
| | 0.9 | | | | | | | | | | | | | |
| | 0.8 | | | | B | B | | | | | | | | |
| | 0.7 | | | | B | A | B | | | | | | | |
| | 0.6 | | | | B | B | A | B | | | | | | |
| | 0.5 | | | | | B | A | A | B | | | | | |
| | 0.4 | | | | | | B | A | B | B | | | | |
| | 0.3 | | | | | | B | A | A | A | B | | | |
| | 0.2 | | | | | | | B | B | A | B | | | |
| | 0.1 | | | | | | | | | B | B | | | |
| | 0 | | | | | | | | | | | | | C |

| | | | | | | | | | | | | | | |
|---|---|---|---|---|---|---|---|---|---|---|---|---|---|---|
| Evaluation A: Good Evaluation B: Feasible Evaluation C: Infeasible | | | | | | | | | | | | | | |

The composition analysis results described here are the average value measured by simultaneous oxygen and nitrogen analysis method.

As shown in Table 2, it is understood that the composition of the protective film in which excellent releasability is obtained satisfies 1.1 ≤ X ≤ 1.7 and 0.1 ≤ Y ≤ 0.8. In the samples having the evaluations "A" and "B", as a result of X-ray diffraction, a peak showing silicon nitride (Si₃N₄) was not detected. From this fact, it is considered that good releasability can be obtained owing to the state of an oxynitride film.

### (Example 5: Formation of protective film of dense body and its evaluation)

A fused quartz-made crucible main body having an inner volume of 678 mm x 678 mm x 400 mm was held at 1,100°C for 5 hours in a mixed gas atmosphere in which hydrogen and ammonia were adjusted to 1:5 in volume ratio, thereby forming on the surface thereof a protective film of a dense body having a composition of SiO_{X}N_{Y} (X > 0 and Y > 0) and in which a peak showing silicon nitride (Si3N4) was not detected in the same X-ray diffraction as Example 1.

Furthermore, for the evaluation of composition of the protective film, a protective film of a dense body was formed on the surface of a fused quartz-made plate-like material of 100 mm x 100 mm x 10 mm under the same conditions as above. As a comparative example, a crucible and a plate-like material, provided with a protective film of a dense body in which the surface thereof is Si₃N₄, that is, a peak showing Si₃N₄ was detected as a result of X-ray diffraction, were prepared.

### (Evaluation results)

The protective film formed by the above method was evaluated in the same manner as in Example 1. A sample having a protective film of a dense body in which a peak showing Si₃N₄ was not detected as a result of X-ray diffraction had the evaluation "A", and excellent releasability was obtained. However, a sample having a protective film of a dense body in which a peak showing Si₃N₄ was detected had the evaluation "C", and considerable breakage was generated in the silicon block.

The fourth embodiment of the invention is described in detail below by reference to the examples.

### (Example 6)

High-purity SiO₂ powder (purity is 99.9% or more; an average particle diameter is 100 nm; and the total concentration of alkali metal, alkali earth metal, fluoride, chloride, carbon, iron, chromium, cobalt, nickel, tungsten, molybdenum and titanium is 2 ppm) was held at 1,100°C for 5 hours in a mixed gas atmosphere in which hydrogen and ammonia were adjusted to 1:3 in volume ratio to prepare SiO_{X}N_{Y} powder.

A suspension was prepared by mixing the SiO_{X}N_{Y} powder thus obtained and high-purity SiO₂ powder (purity is 99.9% or more; an average particle diameter is 5 nm; and the total concentration of alkali metal, alkali earth metal, fluoride, chloride, carbon, iron, chromium, cobalt, nickel, tungsten, molybdenum and titanium is 2 ppm) in the weight ratio of 0.1 wt% based on the SiO_{X}N_{Y} powder, and using pure water and PVA.

Each suspension prepared was sprayed to an inner surface of a fused quartz-made crucible main body having an inner volume of 678 mm x 678 mm x 400 mm, and dried. The spray coating and drying were repeated until the film thickness reaches 500 µm. Thus, a coating film was formed.

The crucible having the coating film thus formed was held in a non-oxidizing atmosphere at 800 °C for 60 minutes in a state that given pores remained in the inside of the coating film, thereby forming a protective film. Thus, the crucible having formed thereon a protective film containing SiO_{X}N_{Y} particles and SiO₂ particles was prepared.

### (Example 7)

High-purity Si₃N₄ powder (purity is 99.9% or more; an average particle diameter is 100 nm; and the total concentration of alkali metal, alkali earth metal, fluoride, chloride, carbon, iron, chromium, cobalt, nickel, tungsten, molybdenum and titanium is 2 ppm) was held at 800°C for 5 hours in an air atmosphere to prepare SiO_{X}N_{Y} powder.

The subsequent procedures were conducted in the same methods as in Example 6 to prepare a crucible having formed thereon a protective film containing SiO_{X}N_{Y} particles and SiO₂ particles.

### (Comparative Example 1)

A crucible having formed thereon a protective film containing only SiO_{X}N_{Y} particles was prepared in the same manner as in Example 6, except that the high-purity SiO₂ powder having an average particle diameter of 5 nm was not used.

### (Comparative Example 2)

A crucible having formed thereon a protective film containing only SiO_{X}N_{Y} particles was prepared in the same manner as in Example 7, except that the high purity SiO₂ powder having an average particle diameter of 5 nm was not used.

### (Comparative Example 3)

High-purity Si₃N₄ powder (purity is 99.9% or more; an average particle diameter is 100 nm; and the total concentration of alkali metal, alkali earth metal, fluoride, chloride, carbon, iron, chromium, cobalt, nickel, tungsten, molybdenum and titanium is 2 ppm) was heated at 1,000°C for 3 hours in an air atmosphere to prepare Si₃N₄ powder having an oxide film (SiO₂) formed on the surface of Si₃N₄ particles.

A suspension was prepared using the Si₃N₄ powder thus obtained, pure water and PVA, without using the high-purity SiO₂ powder having an average particle diameter of 5 nm.

Each suspension prepared was sprayed to an inner surface of a fused quartz-made crucible main body having an inner volume of 678 mm x 678 mm x 400 mm, and dried. The spray coating and drying were repeated until the film thickness reaches 500 µm. Thus, a coating film was formed.

The crucible having the coating film thus formed was held in a non-oxidizing atmosphere (argon atmosphere) at 800°C for 60 minutes such that Si₃N₄ powders were welded with each other in a state that given pores remained in the inside of the coating film, thereby forming a protective film. Thus, the crucible having formed thereon a protective film having containing the Si₃N₄ powder was prepared.

### (Comparative Example 4)

A crucible having formed thereon a protective film containing only the SiO₂ particles was prepared in the same manner as in Example 6, except that SiO_{X}N_{Y} powder was not prepared, and only the high-purity SiO₂ powder (purity is 99.9% or more; an average particle diameter is 100 nm; and the total concentration of alkali metal, alkali earth metal, fluoride, chloride, carbon, iron, chromium, cobalt, nickel, tungsten, molybdenum and titanium is 2 ppm) was used.

### (Evaluation of wettability between protective film and silicon)

A polycrystal silicon bulk was placed in the crucible prepared above, and heated to prepare a silicon melt, and the melt was then cooled to solidify the same. A sample that crucible pieces could be removed from the silicon block thus prepared without difficulty was evaluated "A", a sample that crucible pieces could be removed in a state that slight cracks were generated in the finally solidified portion of the silicon block was evaluated "B", and the sample that the silicon block and the crucible were adhered over a wide area, crucible pieces could not easily be removed and considerable breakages were generated in the silicon block was evaluated "C".

### (Evaluation results)

The evaluation results of wettability between the protective film formed and silicon are shown in Table 3.

**TABLE 3**

| | Wettability |
|---|---|
| Example 6 | A |
| Example 7 | A |
| Comparative Example 1 | B |
| Comparative Example 2 | B |
| Comparative Example 3 | B |
| Comparative Example 4 | C |

As is understood from the above results, the results of Examples 6 and 7 were best, and Comparative Examples 1 to 3 were substantially the same level.

As a result of observing the cross section of the protective films in Examples 6 and 7, it was confirmed that the protective film had the particle structure as shown in Fig. 5.

A fifth embodiment of the invention is described in detail below by reference to the examples.

### (Example 8)

High-purity SiO₂ powder (purity is 99.9% or more; an average particle diameter is 100 nm; and the total concentration of alkali metal, alkali earth metal, fluoride, chloride, carbon, iron, chromium, cobalt, nickel, tungsten, molybdenum and titanium is 2 ppm) was held at 1,100°C for 5 hours in a mixed gas atmosphere in which hydrogen and ammonia were adjusted to 1:3 in volume ratio to prepare SiO_{X}N_{Y} powder.

The SiO_{X}N_{Y} powder thus obtained was held at 800°C for 5 hours in an air atmosphere to form an oxide film having a thickness of 5 nm on the surface thereof.

A suspension was prepared by using the SiO_{X}N_{Y} powder having the oxide film formed thereon, pure water and PVA.

The suspension prepared was sprayed to an inner surface of a fused quartz-made crucible main body having an inner volume of 678 mm x 678 mm x 400 mm, and dried. The spray coating and drying were repeated until the film thickness reaches 500 µm. Thus, a coating film was formed.

The crucible having the coating film thus formed was held in an argon atmosphere at 800°C for 60 minutes such that the SiO_{X}N_{Y} powders having the oxide film formed thereon were welded with each other in a state that given pores remained in the inside of the coating film, thereby forming a protective film. Thus, the crucible having a protective film having SiO_{X}N_{Y} powder in which the oxide film was formed on the surface thereof was prepared.

### (Example 9)

High-purity Si₃N₄ powder (purity is 99.9% or more; an average particle diameter is 100 nm; and the total concentration of alkali metal, alkali earth metal, fluoride, chloride, carbon, iron, chromium, cobalt, nickel, tungsten, molybdenum and titanium is 2 ppm) was held at 800°C for about 5 hours in an air atmosphere to prepare SiO_{X}N_{Y} powder in which an oxide film was formed on the surface thereof and a direct inner surface to the oxide film had SiO_{X}N_{Y} (X > 0 and Y > 0) composition.

The subsequent procedures were conducted in the same manner as in Example 8 to prepare a crucible having formed thereon a protective film containing SiO_{X}N_{Y} powder in which an oxide film was formed on the surface thereof.

### (Comparative Example 5)

High-purity Si₃N₄ powder (purity is 99.9% or more; an average particle diameter is 100 nm; and the total concentration of alkali metal, alkali earth metal, fluoride, chloride, carbon, iron, chromium, cobalt, nickel, tungsten, molybdenum and titanium is 2 ppm) was held at 1,000°C for 3 hours in an air atmosphere to prepare Si₃N₄ powder having only an oxide film having a thickness of 5 nm formed on the surface thereof.

The subsequent procedures were conducted in the same manner as in Example 8 to prepare a crucible having formed thereon a protective film containing Si₃N₄ powder in which only an oxide film was formed on the surface thereof.

### (Comparative Example 6)

A crucible having formed thereon a protective film having only SiO₂ particles was prepared in the same manner as in Example 8, except for using only high purity SiO₂ powder (purity is 99.9% or more; an average particle diameter is 100 nm; and the total concentration of alkali metal, alkali earth metal, fluoride, chloride, carbon, iron, chromium, cobalt, nickel, tungsten, molybdenum and titanium is 2 ppm) without using SiO_{X}N_{Y} powder.

### (Wettability between protective film and silicon)

A polycrystal silicon bulk was placed on the inner surface of the crucible prepared above, and melted at high temperature to prepare a silicon melt, and the melt was then cooled and solidified. A sample that crucible pieces could be removed from the silicon block thus prepared without difficulty was evaluated "A", a sample that crucible pieces could be removed in a state that slight cracks were generated in the finally solidified portion of the silicon block was evaluated "B", and the sample that the silicon block and the crucible were adhered over a wide area, crucible pieces could not easily be removed and considerable breakages were generated in the silicon block was evaluated "C".

Furthermore, when the polycrystal silicon was placed on the inner surface of the crucible, the polycrystal silicon was intentionally hit to the protective film several times with the same force, and the peeling state of the portion was visually observed.

### (Evaluation results)

The evaluation results of wettability between the protective film formed and silicon, and peeling state are shown in Table 4.

**TABLE 4**

| | Wettability | Peeling state |
|---|---|---|
| Example 8 | A | No peeling |
| Example 9 | A | No peeling |
| Comparative Example 5 | B | Slight peeling |
| Comparative Example 6 | C | No peeling |

As can be seen from the above results, the crucibles of Examples 8 and 9 have good wettability to silicon, and peeling of the protective film was not confirmed. Contrary to this, in Comparative Example 5, slight peeling was confirmed on the outermost surface of the protective film. Furthermore, slightly poor result was confirmed in wettability as compared with Examples 8 and 9. This is considered due to that the silicon block was adhered to the inner surface of the crucible in the protective film-peeled portion. In Comparative Example 6, peeling of the protective film was not confirmed, but wettability was very poor.

As a result of evaluation of the cross section of the protective films in Examples 8 and 9 with SEM, it was confirmed to have the particle structure as shown in Fig. 9.

While the present invention has been described in detail and with reference to specific embodiments thereof, it will be apparent to one skilled in the art that various changes and modifications can be made therein without departing from the scope thereof.

This application is based on Japanese Patent Application No. 2008-121545 filed May 7, 2008, Japanese Patent Application No. 2008-250628 filed September 29, 2008 and Japanese Patent Application No. 2008-250814 filed September 29, 2008, the contents of which are incorporated herein by reference in their entities.

## Claims

1. A crucible for melting silicon comprising a crucible main body comprising a heat-resistant member, and a protective film formed at least on an inner surface of the crucible main body,
wherein the protective film has a composition of SiO_{X}N_{Y} in which X > 0 and Y > 0.

2. The crucible for melting silicon according to claim 1, wherein the protective film is constituted of a sintered body of a powder having a single composition of SiO_{X}N_{Y} in which X > 0 and Y > 0.

3. The crucible for melting silicon according to claim 2, wherein the composition of SiO_{X}N_{Y} satisfies 0.2 ≤ X ≤ 0.8 and 0.8 ≤ Y ≤ 1.2.

4. The crucible for melting silicon according to claim 2, wherein the protective film has such a composition gradient that Y is decreased and X is increased toward the depth direction thereof from the surface thereof.

5. The crucible for melting silicon according to claim 1, wherein the protective film is constituted of a sintered body of a powder having a composition of SiO_{X}N_{Y} in which X > 0 and Y > 0, and
wherein the powder is an aggregate of fine particles having such a composition gradient that Y is decreased and X is increased toward the depth direction thereof from the surface thereof.

6. The crucible for melting silicon according to claim 1, wherein the protective film is constituted of a dense body, and has such a composition gradient that Y is decreased and X is increased toward the depth direction thereof from the surface thereof.

7. The crucible for melting silicon according to claim 1, wherein the protective film contains alkali metal, alkali earth metal, fluoride, chloride, carbon, iron, chromium, cobalt, nickel, tungsten, molybdenum and titanium at a total concentration of 100 ppm or less.

8. The crucible for melting silicon according to claim 1, which is formed by combining a plurality of plate-materials comprising a heat-resistant member having the protective film formed on a surface thereof.

9. A release agent for use in forming a protective film formed at least on an inner surface of a crucible for melting silicon,
wherein the release agent comprises a powder of fine particles having, at least on the surface thereof, a single composition of SiO_{X}N_{Y} in which X > 0 and Y > 0.

10. The release agent according to claim 9, wherein the composition of SiO_{X}N_{Y} satisfies 0.2 ≤ X 5 0.8 and 0.8 ≤ Y ≤ 1.2.

11. A release agent for use in forming a protective film formed at least on an inner surface of a crucible for melting silicon,
wherein the release agent comprises a powder having, at least on the surface thereof, a composition of SiO_{X}N_{Y} in which X > 0 and Y > 0, and
wherein the powder is an aggregate of fine particles having such a composition gradient that Y is decreased and X is increased toward the depth direction thereof from the surface thereof.

12. A crucible for melting silicon comprising a crucible main body comprising a heat-resistant material, and a protective film formed at least on an inner surface of the crucible main body,
wherein the protective film comprises first solid particles having, at least on the surface thereof, a composition of SiO_{X}N_{Y} in which X > 0 and Y > 0; and second solid particles having a composition of SiO₂ and having a particle diameter smaller than a particle diameter of the first solid particles, and
wherein the second particles connect the first solid particles with each other at a part of an interface between the first solid particles.

13. A release agent for use in forming a protective film formed at least on an inner surface of a crucible for melting silicon,
wherein the release agent comprises a powder comprising first solid particles having, at least on the surface thereof, a composition of SiO_{X}N_{Y} in which X > 0 and Y > 0; and second solid particles having a composition of SiO₂ and having a particle diameter smaller than a particle diameter of the first solid particles.

14. A crucible for melting silicon comprising a crucible main body comprising a heat-resistant material, and a protective film formed at least on an inner surface of the crucible main body,
wherein, in the protective film, a plurality of solid particles in which an oxide film is formed on the surface thereof and a direct inner layer of the oxide film has a composition of SiO_{X}N_{Y} in which X > 0 and Y > 0 are connected with each other through the oxide film.

15. A release agent for use in forming a protective film formed at least on an inner surface of a crucible for melting silicon,
wherein the release agent comprises a powder comprising a plurality of solid particles in which an oxide film is formed on the surface thereof and a direct inner layer of the oxide film has a composition of SiO_{X}N_{Y} in which X > 0 and Y > 0.
